# EUROPEAN PATENT APPLICATION

(11) **EP 4 576 950 A1**
(43) Date of publication of application: **25.06.2025**
(21) Application number: 23218248.5
(22) Date of filing: 19.12.2023
(51) Int. Cl.: H05K 3/46, H05K 1/18, H05K 3/42, H05K 1/02, H05K 1/03

(54) **COMPONENT CARRIER WITH STACKS CONNECTED BY INTERMEDIATE LAYER, AND MANUFACTURING METHOD**

(71) Applicant: AT & S Austria Technologie & Systemtechnik Aktiengesellschaft, 8700 Leoben-Hinterberg (AT)
(72) Inventor: Oggioni, Stefano Sergio, 8700 Leoben (AT); Kirchheimer, Karl Philipp, 9500 Villach (AT)
(74) Representative: Dilg, Haeusler, Schindelmann Patentanwaltsgesellschaft mbH

(57) **Abstract**

There is described a component carrier (150), wherein the component carrier (150) comprises:
i) a first stack (160) comprising at least one first electrically conductive layer structure (164) and at least one first electrically insulating layer structure (162), and having a first cavity (166) in which a first component (165) is embedded, wherein said first cavity (166) is open on a first main surface of the first stack (160);
ii) a second stack (170) comprising at least one second electrically conductive layer structure (174) and at least one second electrically insulating layer structure (172), and having a second cavity (176) in which a second component (175) is embedded,
wherein the second cavity (176) is open on a second main surface of the second stack (170) and faces the first main surface of the first stack (160);
iii) an intermediate layer (100), wherein the intermediate layer (100) is arranged between the first stack (160) and the second stack (170), and comprises:
a) stiffening layer (110) comprising a stiffening structure in an intermediate resin portion (110),
b) a first resin portion (120) arranged at a first main surface (115) of the stiffening layer (110),
wherein the first resin portion (120) is arranged at least partially in gaps (167) of the open first cavity (166) between the first component (165) and the first stack (160), and
c) a second resin portion (130) arranged at a second main surface (116) of the stiffening layer (110) opposed to the first main surface (115), wherein the second resin portion (130) is arranged at least partially in gaps (177) of the open second cavity (176) between the second component (175) and the second stack (170).

## Description

### Field of the Invention

The invention relates to a component carrier with at least two stacks that are connected by an intermediate layer which comprises a stiffening layer. Each stack comprises at least one cavity with a respective embedded component. Hereby, the cavities are open towards the intermediate layer, so that resin from the intermediate layer flows at least partially into the respective cavities, thereby embedding the respective component. Further, the invention relates to a method of manufacturing said component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

Especially embedding a component, in particular a plurality of components at different vertical heights (in stacking direction), into a component carrier may still be considered a challenge. Conventionally, in the process of embedding components into substrates, the actual process may require to place the component(s) into cavity/cavities made into a core layer, and then to have this/these cavity/cavities filled with a resin, for example provided by lamination with a B-stage (not fully cured) pre-preg sheet placed on top of the core layer. So far, the substrate manufacturing process may require providing a single core layer, so that the aforementioned process may work fine to fulfill some product requirements.

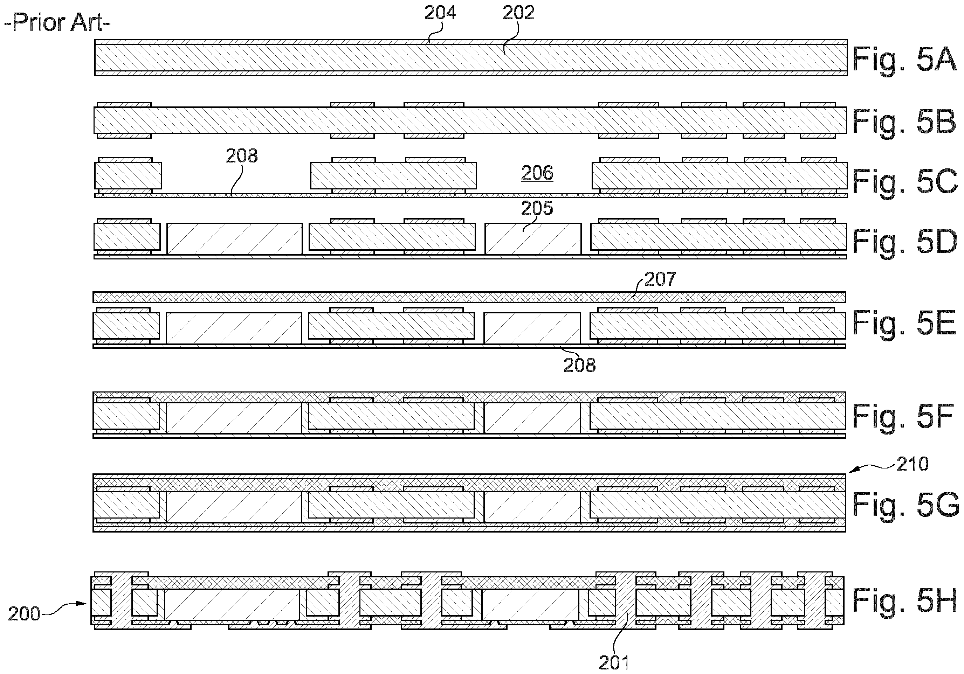

**Figure 5** illustrates a conventional example of embedding components into a substrate.

Figure 5A: a core is provided, here a copper-clad laminate with a fully cured resin layer 202 sandwiched between two copper foils 204.

Figure 5B: the copper foils 204 are patterned to form traces.

Figure 5C: slots 206 are formed (e.g. by drilling) in the resin layer 202. Further, a sticky tape 208 is provided on the bottom by lamination.

Figure 5D: components 205 are placed in the slots 206 onto the sticky tape 208.

Figure 5E: a (not fully cured) prepreg layer 207 is placed on top of the components 205.

Figure 5F: during a lamination process, a part of the prepreg layer 207 is pressed into the slots 206 to encapsulate the components 205.

Figure 5G: the sticky tape 208 is removed and additional copper (plating) and resin (lamination) layers 210 are provided.

Figure 5H: by drilling, electrical through-connections 201 are formed. Further, the copper layers are patterned, so that the final substrate 200 is provided.

However, in recent developments and product evolutions it may be required to consider the use of multiple cores/stacks with embedded components, also on different vertical heights. According to the conventional approach, this would require to repeat the process for each core layer individually prior of their lamination and stacking them together to achieve the required functional construction.

### Summary of the Invention

There may be a need to provide a component carrier with embedded components at different vertical heights in an efficient and robust manner.

A component carrier and a manufacturing method are described.

According to an aspect of the invention, there is described a component carrier (e.g. a (multi-core) printed circuit board) comprising:
i) a first stack comprising at least one first electrically conductive layer structure and/or at least one first electrically insulating layer structure, and having a first cavity in which a first component (e.g. an active component such as semiconductor element) is embedded (encapsulated), wherein said first cavity is open (in particular free of a cover structure, so that a material from a first side of an intermediate layer may enter said cavity) on a first main surface of the first stack;
ii) a second stack comprising at least one second electrically conductive layer structure and at least one second electrically insulating layer structure and having a second cavity in which a second component (e.g. a passive component such as a capacitor) is embedded, wherein the second cavity is opened (in particular free of a cover structure, so that a material from a second side of the intermediate layer may enter said cavity) on a second main surface of the second stack and faces the first main surface of the first stack;
iii) an intermediate layer (in particular an inlay; comprising three or more layers), wherein the intermediate layer is arranged between the first stack and the second stack, and comprises:
   iiia) a stiffening layer (e.g. an already cured layer such as a core layer) comprising a stiffening structure (e.g. in form of a mesh, for example (glass) fibers) in an intermediate resin portion (e.g. an expoy resin);
   iiib) a first resin portion (in particular non-(fiber-)reinforced) arranged at a first main surface of the stiffening layer, wherein the first resin portion is arranged at least partially in gaps of the open first cavity between the first component and the first stack; and
   iiic) a second resin portion (in particular non-(fiber-)reinforced) arranged at a second main surface of the stiffening layer opposed to the first main surface,
   wherein the second resin portion is arranged at least partially in gaps of the open second cavity between the second component and the second stack.

According to a further aspect of the invention, there is described a method of manufacturing a component carrier, wherein the method comprises:
i) inserting a first component in a first cavity of a first stack comprising at least one first electrically conductive layer structure and at least one first electrically insulating layer structure, wherein the first cavity is open on a first main surface of the first stack;
ii) inserting a second component in a second cavity of a second stack comprising at least one second electrically conductive layer structure and at least one second electrically insulating layer structure, wherein the second cavity is open on a second main surface of the second stack and faces the first main surface of the first stack;
iii) connecting the first stack with the second stack by an intermediate layer that faces the first main surface of the first stack and the second main surface of the second stack, wherein the intermediate layer comprises:
   a) a stiffening layer comprising a stiffening structure in an intermediate resin portion,
   b) a first resin portion arranged at a first main surface of the stiffening layer, and
   c) a second resin portion arranged at a second main surface of the stiffening layer opposed to the first main surface,
   wherein the stiffening layer, the first resin portion, and the second resin portion are at least partially uncured; and
iv) filling at least partially first gaps of the first cavity between the first component and the first stack with material of the first resin portion and second gaps of the second cavity between the second component and the second stack with material of the second resin portion, in particular during a resin curing phase.

In the present context, the term "intermediate layer" may refer to a small stack of at least three layers (or exactly three layers). Such an intermediate layer may be suitable to be placed between two component carrier layer stacks and to interconnect said two stacks. The intermediate layer may be hereby a discrete element, in other words a stand-alone device, that may be used as an inlay for the component carrier manufacture. In an example, the intermediate layer may be manufactured independent of the stacks to be interconnected. In a preferred example, the intermediate layer may comprise at least one stiffening layer, sandwiched between at least two resin portions/layers. While the stiffening layer may be configured to provide a certain degree of stiffness (stability), the resin portions may be used to fill gaps between cavities and cavity-embedded components of the respective stacks. Yet, in a further example, also intermediate resin from the stiffening layer may (partially) be used for gap filling. Preferably, the intermediate layer may be free from electrically conductive material, in particular metal, for example copper and/or nickel and/or titanium.

In the present context, the term "stiffening layer" may refer to a layer (structure) that may be configured to provide a stiffness to the intermediate layer. Such a stiffness may be provided by stiffeners (stiffening material, stiffening particles), for example reinforcing fibers and/or fillers (particles). Such stiffeners may be embedded in a matrix material, e.g. a resin matrix. While in one example, the stiffening layer may be (fully) cured/hardened (e.g. C-stage), in another example, the stiffening layer may be not fully cured (e.g. B-stage). In the later case, resin from the first resin portion may flow through the stiffening layer (in particular through a stiffening mesh of the stiffening layer) to the second resin portion (or the other way around).

Additionally or alternatively, the stiffening layer may comprise an inorganic layer structure, or it might comprise inorganic fillers such as SiO₂ fillers. The fillers might enhance the stiffness of the stiffening layer from the mechanical stability point of view on the one hand. On the other hand, it could also improve the electrical performance of the stiffening layers with different size and/or amount and/or form of fillers, when it behaves as a dielectric layer structure in the component carrier.

In the present context, the term "gap" may refer to a volume in a component carrier stack, that may be filled by a resin flow portion. For example, a cavity to be filled with resin may be seen as a gap. In the present context, a component is placed in said cavity, so that gaps may then be located between stack/cavity (sidewalls) and component (sidewalls). Further, there may be a gap between component and the bottom of the cavity (e.g. when the height of the component is slightly increased, e.g. by an electric structure). Furthermore, between electric connections (e.g. pads, terminals) of the component/cavity bottom/sidewalls, there may be other gaps present. The cavity (and the gaps) may be preferably open towards a respective resin portion of the intermediate layer in order to enable a flow of resin into said cavity/gap.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

According to an exemplary embodiment, the invention may be based on the idea that a component carrier with embedded components at different vertical heights may be provided in an efficient and robust manner, when the components are embedded in different stacks, which are then interconnected vertically (on top of each other) by an intermediate layer. Said intermediate layer may herby fulfill two functions: i) a stiffener to make the component carrier (under manufacture) more robust (by a stiffening layer), and ii) (simultaneously) filling gaps between stack and component within the top stack and the bottom stack (with respect to the intermediate layer) at the same time by respective resin portions of the intermediate layer (resin of the first resin portion, the second resin portion, resin of the stiffening layer) that partially flow into said gaps. The stiffener itself also provides the mechanical stability for the stacks of component carrier, which could reduce the warpage issue of panels.

The described approach may enable high design flexibility when building-up a component carrier in the vertical directions by two or more layer stacks that already contain embedded components. For example, the cavities/components of different stacks may be (at least partially) laterally displaced one to each other.

Furthermore, such kind of design with two stacks on both side of stiffeners provides a symmetrical structure for a component carrier with components embedded in both stacks, therefore the design of symmetrical structure could have a balance of modulus of two stacks to mitigate the warpage of the whole component carrier.

The described approach may enable shorter production cycle time with fewer lamination steps, thinner stack-ups, and less material use. Further, a plurality of specific requirements may be enabled such as HF, photonics embedding, wave channels, optical wave propagation paths, thermal improvements, high/low flow resins combinations, etc.

### Exemplary Embodiments

According to an embodiment, the first cavity (the first component) and the second cavity (the second component) are (at least partially) laterally displaced with respect to each other, in particular with respect to the vertical direction (z). In other words, said cavities/components are shifted/offset in the horizontal plane (x, y), so that they do not overlap along a vertical axis (z).

Conventionally, components are embedded in the same (horizontal) layer of a stack, normally in the one core layer of a single core stack. In case that two or more components are used in the vertical direction, conventionally, single core stack are placed one upon the other, so that the components of the different single core stack are placed directly on top of each other (stacked on top of each other in the vertical direction).

Thus, a shift of the component/cavity location with respect to the z-axis may reflect a completely different manufacture process: pre-fabricated stacks with respective cavities/components are interconnected using an intermediate layer, that provides at the same time a stiffening function and an encapsulation (by resin flow) of the components in the cavities. Thereby, a high design flexibility (and accordingly especially adjusted applications) may be obtained, which may be reflected e.g. in laterally displaced components. Additionally, even if the first and the seconds cavities are laterally displaced one to each other, the structure of the intermediate layer allows a reliable and full arrangement of the first and the second resin portions in the respective gaps without be affected by the misaligned cavities.

In an embodiment, that the first cavity and/or the second cavity is facing (and open) towards the intermediate layer.

In an embodiment, the first cavity and/or the second cavity can be formed at the same process step by panel flip, therefore it can provide a symmetric structure of the component carrier to mitigate the warpage issue. Meanwhile such kind of structure with intermediate layer in the middle to provide the mechanical stability could control the die shift after die mounting in the cavity and the encapsulation for the gap.

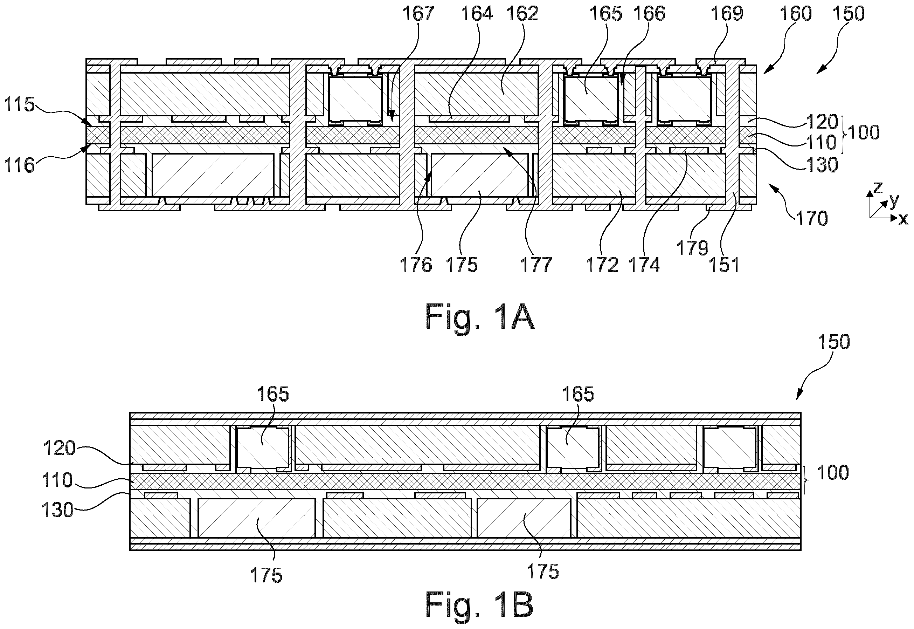

According to an embodiment, the first cavity and the second cavity do not overlap one to each other along the vertical direction (z). In this embodiment, there is no overlap of the first cavity/component and the second cavity/component along a vertical axis (see e.g. Figure 1). In the vertical direction, the component carrier may be divided into first cavity/component regions and second cavity/component regions. In this manner, electrically contacting individual components may be more efficient and reliable. Further, heat produced by respective components may be distributed more efficiently, when each component has more space to radiate heat into the environment.

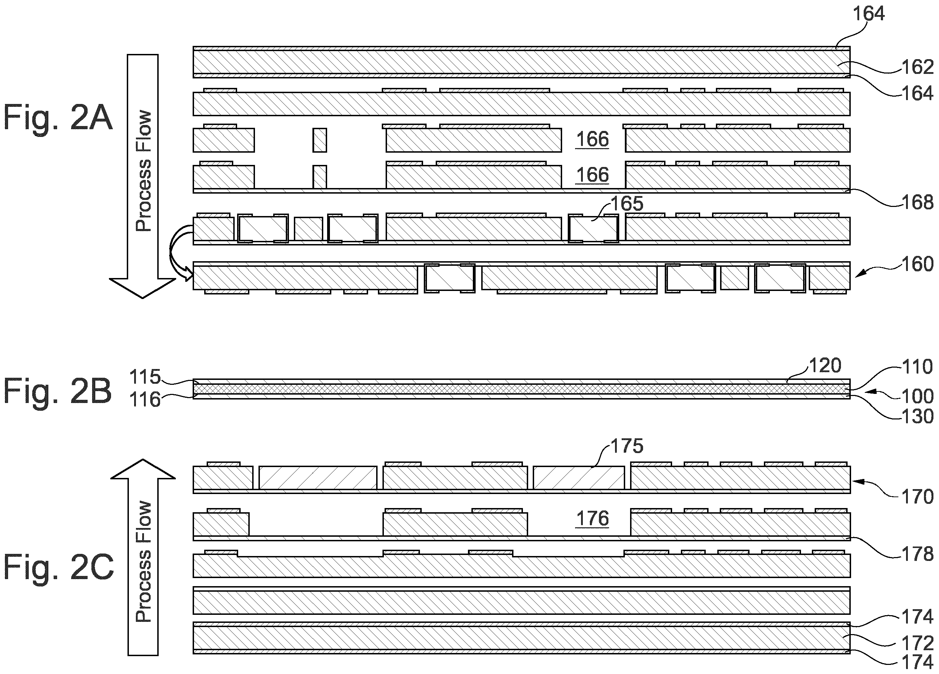

According to an embodiment, the first cavity and the second cavity (only) partially (or fully) overlap one to each other along the vertical direction (z). In this embodiment, there is a partial overlap of the first cavity/component and the second cavity/component along a vertical axis (see e.g. Figure 2). The above described advantages may also apply in this case. Further, (partially) overlapping components may be electrically interconnected more efficiently, since they are spatially close to each other. Since there may still be some offset left, individual component connection and/or heat distribution may still be realized in an efficient manner.

According to an embodiment, a first volume of said gaps in the first cavity is different from a second volume of said gaps in the second cavity. This structural feature may reflect a high degree of design flexibility, e.g. implementing the first stack and the second stack in a (completely) different manner, depending on desired applications. For example, a plurality of passive components (such as capacitors) may be embedded in the first stack. These may require little space, but if a high number is embedded, a high volume of gaps may be required. In a further example, a plurality of active components (e.g. semiconductor elements) may be embedded in the second stack. If for example, only two semiconductor elements are embedded, the volume of the gaps in the second stack may be lower than in the first stack, even though the active elements may require larger cavities than the passive elements. Depending on the desired application, a large variety of options are possible here.

With such kind of structure, there might be a different thickness of the first resin portion compared to the thickness of the second resin portion on both respective sides of the intermediate layer. Conventionally, it might have warpage problem due to the different young modulus of different dielectric layer thickness. However, the warpage can be compensated by the stiffness of the intermediate layer for this design, therefore this approach may provide a high flexibility for different design from production point of view.

According to an embodiment, the stiffening structures of the stiffening layer comprise a plurality of through openings (e.g. in a mesh), configured so that the resins of the intermediate resin portion, the first resin portion, and the second resin portion are (in particular monolithically) (inter-) connected one to each other. This may provide the advantage that the layers of the intermediate layer are interconnected in a stable manner. The resin material of the (at least) three portions may be the same, similar or different.

According to an embodiment, the stiffening structures of the stiffening layer comprise stiffening fibers. According to an embodiment, the stiffening fibers form a mesh with the plurality of through openings. For example, the (glass) fibers may be arranged in a first direction and a second direction, wherein said directions are (essentially) perpendicular to each other. In this manner, a stable fiber network (in particular woven) may be obtained. By arranging the fibers in a specific manner (e.g. as bundles), through holes may be provided. By using energy, the strand of the network may be enlarged/flattened.

In the described manners, two advantages may be achieved at the same time: i) the fiber mesh/network provides stability/stiffness, while ii) the through holes/openings enable a (controlled) flow of (uncured) resin portions through the mesh, so that flexible resin flow streams and/or robust layer interconnection in the intermediate layer may be realized.

According to an embodiment, the resin of at least one of the intermediate resin portion of the stiffening layer, the first resin portion, the second resin portion, comprises fillers (fibers and/or filler particles, e.g. spheres such as glass spheres). The fillers may stabilize the respective layer and/or the stack. Further, the filers may provide information with respect to distinct flowed resin portions.

In an example, the term "filler" may refer to a material embedded in a resin matrix, wherein the filler material is different from the matrix material. In particular, the filler material is harder than the resin material, thereby providing a reinforcing effect. In case that the resin material is in an uncured (not fully cured) state, the filler material may move (be transported) within the matrix material and/or flow together with the matrix material. The filler might be made of from an inorganic layer structure.

In an example, fibers may be preferably applied to provide a certain stiffness to a layer structure, e.g. a prepreg. In a preferred example, the fibers are arranged in form of a network, wherein two fiber directions of main extension are perpendicular to each other.

In another example, filler particles, such as spheres, may be used to provide a certain flexibility (in addition to stability) to a layer structure, e.g. Ajinomoto build-up film (ABF). It can adjust the hardness of the dielectric layer and the electrical resistance of dielectric layer.

According to an embodiment, the plurality of through openings is configured to allow the passage of at least a portion of the fillers through said through openings, in particular wherein the size/shape (average dimensions) of the fillers is lower than the average dimensions of the through openings. By choosing the size/shape of the fillers and/or the openings appropriately, at least a part of the fillers may be enabled to flow through the mesh.

Based on the distribution of the fillers, the flow direction/extension of the respective flowed resin portions may be clearly observable. In this manner, a monitoring of the (distinct) resin flow directions may be enabled, e.g. in order to quality-check and/or further optimize/adjust the resin flow parameters. Furthermore, the fillers may enhance the stability of the layer stack, in particular by flowing into other portions/gaps and thereby stabilizing the intermediate layer and/or the cavity/component.

According to an embodiment, at least one resin of the intermediate resin portion of the stiffening layer, the first resin portion, the second resin portion, has a flow direction towards the first cavity and/or the second cavity. In other words, the resin flows towards the local need of additional resin and/or the case of local presence of gaps/recesses where said resin is needed (enabled to flow into). This may enable a reliable resin flow distribution and robust embedding, thereby avoiding unfilled gaps. In an example, the mesh may be designed to enable different flow characteristics at different regions, e.g. by varying the size/shape/amount of through opening.

According to an embodiment, the component carrier further comprises an electrically conductive vertical through connection (e.g. a through via or a blind via; a straight or a tapering via) that passes through at least one of the stiffening layer, the first resin portion, the second resin portion, the intermediate layer, the first stack, the second stack, the whole component carrier stack (i.e. at least the first stack, the second stack, and the intermediate layer). In a further embodiment, the electrically conductive vertical through connection connects two opposed main surfaces of the component carrier (see e.g. Figure 1). This may provide the advantage of an efficient and reliable electrical connection within the component carrier (stack), in particular through the whole component carrier thickness. The electrically conductive vertical through connection may further spatially separate regions (in the vertical direction) of first cavity/component and regions of second cavity/component (when seen in a cross-section).

According to an embodiment, the electrically conductive vertical through connection connects the first component of the first cavity with the second component of the second cavity (indirectly or directly), in particular connects the faced surfaces of said components (in particular when partially overlapping along a z-axis). According to an embodiment, the electrically conductive vertical through connection connects a side of the first component or the second component with a surface of the component carrier and another side of the first component or the second component with a further, in particular opposed, surface of the component carrier.

Thereby, efficient and reliable electrical interconnections in the stack may be realized. The vertical electrically conductive through connection may be electrically connected with at least on electrically conductive structure and/or component in the stack. The vertical electrically conductive through-connection may electrically interconnect external surfaces of the stack and/or embedded components. In the manufacture process, the vertical electrically conductive through-connection may be formed after the embedding process and/or after a lamination step.

In an embodiment, the first and second components can be connected to electrical networks, where these components maybe jointly (directly) or independently (indirectly) connected. Some of these components can be embedded for functions that not necessarily see them being interconnected, these can be connected to other components independently.

In an embodiment, the embedded components (embedded e.g. in the multilayer core) may provide independent functions to other components mounted on the surface of the substrate at a later time.

According to an embodiment, at least one of the intermediate resin portion of the stiffening layer, the first resin portion, the second resin portion, is different to another one of the intermediate resin portion of the stiffening layer, the first resin portion, the second resin portion. In particular, the difference is at least one of the following: a thickness, a material, a light reflection index, a mechanical property, a thermal property (in particular the coefficient of thermal expansion (CTE)), a filler characteristic (in particular one of filler size, filler material, filler shape, filler distribution, fiber-free).

According to an embodiment, one resin portion may have different curing cycle characteristics that may differentiate from the curing cycle characteristics of the other resin portions.

According to an embodiment, the thickness of the first resin portion is different from the thickness of the second resin portion. According to an embodiment, the light reflection index between at least two portions is different (i.e. footprint of different curing degrees among the portions, promoting their flow toward specific direction(s)).

The above described differences may enable a plurality of different applications. Further, these differences may reflect specific manufacture steps, e.g. curing states and/or flow directions. Furthermore, this may bring the advantage of providing a high design flexibility, since the mechanical and/or physical and/or chemical properties of the intermediate layer may be easily changed using the above described method.

According to an embodiment, the resin of at least one of the intermediate resin portion of the stiffening layer, the first resin portion, the second resin portion, fills the first gaps and/or the second gaps in the respective cavity up to the opposed surface of the respective stack, in particular up to an electrically conductive layer structure. Thereby, an efficient and stable encapsulation may be enabled.

The embedded component may comprise one or more electric connections (pads), which may be embedded in resin (flowed) portion(s). At the bottom of the cavity, there may be arranged an electrically insulating layer structure and/or an electrically conductive layer structure (for example blind vias that extend through the electrically insulating layer structure into the cavity (see e.g. Figure 1)). In an example, the component is not directly attached to the bottom of the cavity, but there may be a gap, e.g. due to electric contacts, via contacts, etc. Said gaps may also be filled by flowing resin portion(s). In this manner, the whole cavity, even below the component, may be filled.

According to an embodiment, at least one component, embedded in the first stack, is different from at least one component, embedded in the second stack, in particular one being an active component and the other one being a passive component. This may provide the possibility of high design flexibility for a plurality of different applications.

According to an embodiment, the component carrier comprises a multilayer core with at least one common through conductor element, and comprising different components in different layers. In other words, the component carrier may comprise at least two core layers, wherein each core layer comprises at least one embedded component (provided by interconnecting the two stacks). An especial integration may be enabled, when vias for electrical interconnection between different layers are provided, in particular vias through two or more layers.

According to an embodiment, the component carrier further comprises:
a recess in the stiffening layer, in particular wherein a component (e.g. an active component, a passive component, a thermal element (e.g. a copper block) is at least partially embedded in said recess. Further component embedding may be enabled even within the intermediate layer. The component of the stiffening layer may be used for an electrical and/or thermal connection, e.g. to interconnect components of the first stack and the second stack and/or to transport heat produced from one or more of the components. This may bring the advantage of providing an active function to the stiffening layer. Thereby the functionality of the component carrier may be increased while the exterior dimensions are still the same. Furthermore, the described method may ensure to embedding of the component in the recess in the stiffening layer being void free.

According to an embodiment, the stiffening structure comprises first openings with different dimensions/shape with respect to second openings, in particular wherein openings with larger extension are arranged in proximity of a region with a high filling resin portion requirement. Thereby, the amount of provided/flowing resin may be controlled/adjusted.

According to an embodiment, the method further comprising: applying a vacuum (during the connection of the first stack with the second stack by an intermediate layer). This may bring the advantage of adjusting the physical properties of the first resin portion and/or the second resin portion, since said physical properties are dependent on (the applied) pressure. Moreover, applying vacuum may bring the advantage of ensuring void free filling of the first cavity and/or second cavity with the respective first resin portion or second resin portion, since the applied vacuum ensure fluid-, in particular gas-, free first cavity and/or second cavity. In an example, the vacuum may be a pressure smaller than 900 mbar, in particular smaller than 500 mbar. In another example, the vacuum may be a pressure smaller than 100 mbar, in particular smaller than 30 mbar.

According to an embodiment, the method further comprising:
curing at least one of the first resin portion, the second resin portion, the stiffening layer at least partially during a component carrier lamination process. Thereby, filling the gaps and hardening the flowed resin portions may be combined into one process step.

In the present context, the term "curing" may in particular refer to a hardening of the resin material. For example, a first resin layer may be cured (hardened) to a higher extent than a second resin layer. Accordingly, the second resin layer may have a higher flowability (and lower viscosity) in comparison to the first resin layer. For example, two resin materials are both in a so-called B-stage. In an example, a core layer is already in a partial or fully cured state (C-stage). Additionally, or alternatively, the core layer may comprise an inorganic layer structure. Meanwhile, with the curing process, the CTE of resin can be at least partially released, therefore it can reduce the risk of delamination of dielectric layer and other layers (stress of CTE mismatch can be released).

In an example, in a cured state, the resin material is more cured (hardened) than in an uncured state. In other words, a cure state such as the state of cross-linking and/or the viscosity changes from the uncured state to the cured state (over time). According to a general definition, there are (at least) the following states:
A-stage: no curing (chemical reaction) has not yet started.
B-stage: the curing has started, and the viscosity has begun to increase.
C-stage: the resin is completely cured.

For example, in a pre-cured state, the resin material may be partially able to flow. In contrast to this, a so-called core layer normally comprises fully cured material in order to serve for mechanical stabilization. There are different methods that allow to determine the cure state. In an example, the cure state is predetermined to allow a specific flow amount and/or a specific flow speed. An applied dielectric material may thus be tuned (for example by waiting for a specific time, using temperature curing (elevated temperatures), or hardening with UV light) in order to achieve the desired cure state based on a cure state criterion. In an example, curing may be done by a (any) electromagnetic radiation, e.g. with a wavelength 0.1 to 3000 nm, in particular 10 to 2000 nm, more in particular 100 to 1000 nm. Curing may be also done using a heat source, whereby a source of electromagnetic radiation may also be seen as a heat source.

According to an embodiment, the method further comprising:
controlling flow of at least one of the first resin portion, the second resin portion, the stiffening layer, in particular during curing by adjusting at least one characteristic of a mesh openings/the mesh openings of the stiffening structures of the stiffening layer. Depending on the mesh characteristics, the flow may be controlled/adjusted in an advantageous manner, for example in one region more enhanced than in another region.

According to an embodiment, the at least one characteristic of the mesh openings comprises a number of openings per area and/or a size/shape of the openings. While large opening may enhance a resin flow, smaller openings may reduce the amount of flowed resin. Different sizes and/or number of openings in different regions may enable different resin flows in said different regions. For example, directly above a gap, an increased flow may be desired, while a decreased flow may be preferred on top of the component.

According to an embodiment, the method further comprising:
controlling flow of at least one of the first resin portion, the second resin portion, the stiffening layer by adjusting operation parameters (in particular temperature and/or pressure) during curing (in particular during lamination). This may bring the advantage of predefining the viscosity of the first resin portion and/or second resin portion in order to achieve reliable embedding of the first component in a first cavity and/or a second component in a second cavity and/or connection of the first stack and/or second stack to the intermediate layer.

According to an embodiment, the method further comprising: controlling flow of at least one of the first resin portion, the second resin portion, the intermediate resin of the stiffening layer, in particular by at least one of the following steps:
i) initiating flow of part of the first resin portion into the stiffening layer,
ii) initiating flow of part of the second resin portion into the stiffening layer,
iii) initiating flow of part of the intermediate resin into the first cavity,
iv) initiating flow of part of the intermediate resin into the second cavity,
v) initiating flow of part of the first resin portion into the second cavity (in particular through the mesh),
vi) initiating flow of part of the second resin portion into the first cavity (in particular through the mesh).

Besides the curing control, there may be a plurality of resin flow parameter that may be adjusted to provide an advantageous flow behaviour. Said resin flow parameter may for example comprise at least one of a cure state, a viscosity, a flowability, a resin material, a layer thickness, a filler material, a filler type, an amount of fillers. As described above, a specific selection of the resin layers and their respective resin flow properties may enable a controlled flow of resin portions in the gaps around the component.

According to an embodiment, there is described a semifinished product (an intermediate layer, e.g. as an inlay) for manufacturing a component carrier (e.g. as described above), wherein the semifinished product comprises:
i) a stiffening layer comprising an (at least partially uncured) intermediate resin and stiffening structures;
ii) a (at least partially uncured) first resin layer comprising a first resin and being arranged on a first main surface of the stiffening layer; and
iii) a (at least partially uncured) second resin layer comprising a second resin and being arranged on a second main surface of the stiffening layer opposing the first main surface.

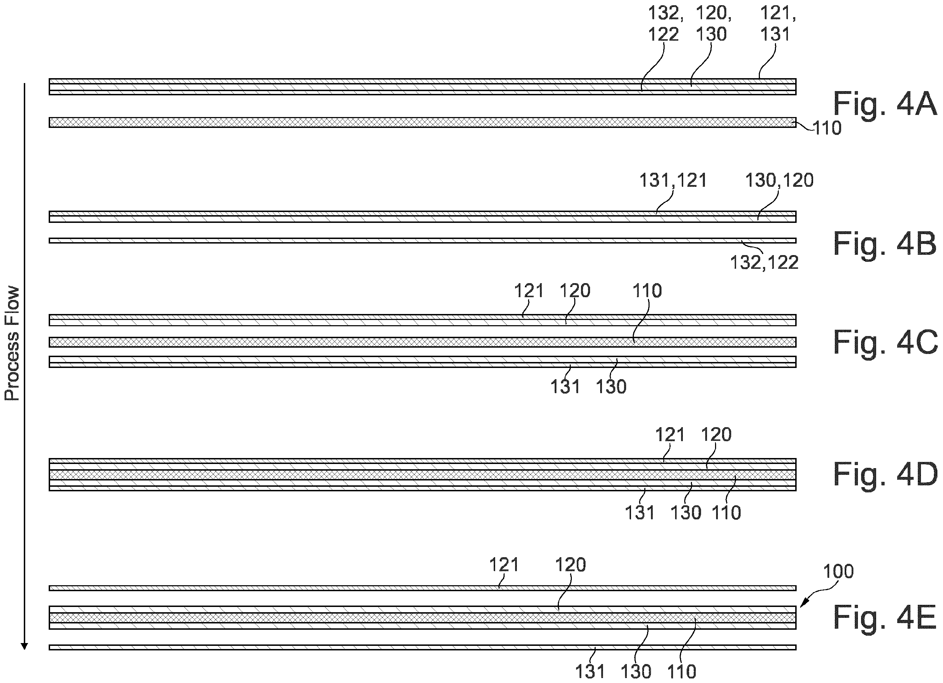

According to an embodiment, the first resin layer and/or the second layer is in direct physical contact with the stiffening layer. Like described in the example of Figure 4, the resin layers may be formed directly on the stiffening layer. Thereby, a thin intermediate layer may be provided as a versatile inlay for a plurality of applications. Due to the stiffening layer, the intermediate layer may be still stable and robust, even though it is a very thin structure.

According to an embodiment, the stiffening structures of the stiffening layer comprise stiffening fibers. This may provide the advantage that established stiffeners/fillers may be directly applied. For example, the stiffening layer may be realized as a (fully cured) prepreg layer and/or an inorganic layer structure. In an example, the fibers may be arranged as a mesh or network, in particular with a least two fiber main directions of extension, wherein said directions are perpendicular to each other.

According to an embodiment the stiffening fibers comprise glass fibers. Glass fibers are well established and may provide a reliable stiffening to the intermediate layer.

According to an embodiment, the stiffening fibers form a mesh with a plurality of through-holes configured for passing resin, in particular the intermediate resin, therethrough. This may provide the advantage that the intermediate layer can be applied in a very (design) flexible manner. Further, the interconnection of stacks may be enhanced in this manner. The mesh can be embedded in resin material of the stiffening layer. In case where the resin is not fully cured, a resin portion from the first resin layer may flow/extend through the mesh to the second resin layer (or beyond) and/or a resin portion from the second resin layer may flow/extend through the mesh to the first resin layer (or beyond).

According to an embodiment, a plurality of stiffening structures are arranged adjacent to each other, in particular in parallel. For example two or more meshes may be arranged next (side-by-side) to each other.

According to an embodiment, the intermediate layer or the component carrier further comprises a further stiffening layer having (at least partially uncured) further resin and further stiffening structures and/or an (at least partially uncured) third resin layer comprising a third resin, wherein the further stiffening layer is arranged between the second resin layer and the third resin layer. By having more layers, a more robust (but also less thin) intermediate layer may be provided.

According to an embodiment, the stiffening layer is configured for spacing electric contacts of the first stack and the second stack, when the intermediate layer is arranged between the first stack and the second stack and is in particular in an at least partially cured state. This may enable an efficient and reliable electric connection within the component carrier.

According to an embodiment, a multilayer core may comprise blind holes (additionally or alternatively to through holes). Such constructions may enable complex circuit architecture through the association of the use of buried/blind/through holes. In an embodiment, the total volume of the first resin portion is larger than the total volume (of the sum) of the first gaps and/or the total volume of second resin portion is larger than the total volume (of the sum) of the second gaps.

In a further embodiment, there can be at least one first cavity in the first stack and/or at least one second cavity in the second stack which is not open and/or not facing towards the intermediate layer. Thereby, design flexibility and performance of specific applications may be increased.

In an embodiment, the thickness of first stack and the second stack is (essentially) the same, but the amount of layers forming the first stacks is different than the amount of layers forming the second stack. Preferably, the amount of layers of one stack may be is less than the amount of the other stack, whereas the thickness of at least one, preferably of each one may be thicker than the layer(s) of the other stack. With such kind of structure, it would also provide the balance of two stacks from the Young modulus point of view to control the warpage.

In an embodiment, at least one of the components is a bridge (die) embedded in the stiffening layer. The bridge (die) can have a both side interconnection which can provide direct electrical connection with the component(s) embedded in the stack at top and bottom side of the stiffening layer. With such kind of structure, the components in the stacks at the top and bottom of stiffening layer can be electrically connected through the bridge embedded in the stiffening layer, significantly shortening the electrical transmission path and improve the signal integrity.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS₂, CuGaO₂, AgAlO₂, LiGaTe₂, AgInSe₂, CuFeS₂, BeO.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figures 1A and 1B respectively show a cross-section of a component carrier, according to exemplary embodiments of the invention.
Figures 2A to 2C show a first part of a manufacture process of a component carrier, according to an exemplary embodiment of the invention.
Figures 3A to 3E show a second part of a manufacture process of a component carrier, according to an exemplary embodiment of the invention.
Figures 4A to 4E show a manufacture process of an intermediate layer, according to an exemplary embodiment of the invention.
Figures 5A to 5H shows a conventional process to embed components on the same vertical level.

### Detailed Description of the Drawings

**Figures 1A and 1B** respectively show a cross-section of a component carrier 150, according to exemplary embodiments of the invention.

**Figure 1A** shows a component carrier 150 (configured as a multi-core printed circuit board), wherein the component carrier 150 comprises a first stack 160 and a second stack 170 interconnected by an intermediate layer 100. The first stack 160 comprises a first electrically conductive layer structure 164 (realized here as metal traces) and a first electrically insulating layer structure 162 (realized here as a resin sheet) and has a first cavities 166 in which respective first components 165 (here passive components, in particular capacitors) are embedded. Additionally or alternatively the first electrically insulating layer structure 162 may comprise a core layer structure and/or an inorganic layer structure. In an example, one first component 165 is embedded in respective one first cavity 166 (see Figure 1A). Alternatively, at least two first components 165 may be embedded in respective one first cavity 166. The second stack 170 comprises a second electrically conductive layer structure 174 and a second electrically insulating layer structure 172 (realized here as a resin sheet) and has second cavities 176 in which respective second components 175 (here active components, in particular semiconductor elements) are embedded. Additionally or alternatively the second electrically insulating layer structure 172 may comprise a core layer structure and/or an inorganic layer structure. In an example, one second component 175 is embedded in respective one second cavity 176 (see Figure 1A). Alternatively, at least two second components 175 may be embedded in respective one second cavity 176.

In an embodiment, the thickness of the first stack 160 regarding stacking direction (z) may be similar, in particular the same, compared to the thickness of the second stack 170. Alternatively, the thickness of the first stack 160 regarding stacking direction (z) may be different compared to the thickness of the second stack 170.

The intermediate layer 100 is arranged between the first stack 160 and the second stack 170 and comprises the following three layers:
i) a stiffening layer 110 in the center, which comprising a stiffening structure (here a mesh of glass fibers) in an intermediate resin portion,
ii) a first resin portion 120 arranged at a first main surface 115 of the stiffening layer 110, and
iii) a second resin portion 130 arranged at a second main surface 116 of the stiffening layer 110 opposed to the first main surface 115.

Additionally or alternatively, the stiffening layer 110 may comprise a core layer structure and/or an inorganic layer structure. In an example, the first resin portion 120 and/or the second resin portion 130 may comprise electrically insulating material, in particular not fully cured electrically insulating material. Optionally, the first resin portion 120 and/or the second resin portion 130 may comprise fillers, for example (glass) spheres and/or (glass) fibers. In an example, the first resin portion 120 and the second resin portion 130 may comprise similar, in particular the same, resin material and/or fillers' composition and/or filler amount or concentration. In a further example, the first resin portion 120 and the second resin portion 130 may comprise different resin material and/or fillers' composition and/or filler amount or concentration.

In an embodiment, the stiffening layer 110 and/or the first resin portion 120 and/or the second resin portion 130 comprises at least one of the group consisting of a resin or a polymer, such as epoxy resin, cyanate ester resin, benzocyclobutene resin, bismaleimide-triazine resin and/or a combination thereof. Additonally and/or alternatively, the stiffening layer 110 and/or the first resin portion 120 and/or the second resin portion 130 may comprise polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof.

In an embodiment, the core (e.g. glass core, ceramic etc.) of the stiffening layer 110 can be at least partially perforated (comprising plurality of through holes). Said through holes can imitate the (glass) mesh described above. In this manner, the first resin portion and/or the second resin portion may be enabled to flow (and mix) with each other through said through holes.

In an embodiment, the thickness regarding stacking direction (z) of the stack 160, 170 of the first resin portion 120 may be similar, in particular the same, compared to the thickness of the second resin portion 130. Alternatively, the thickness regarding stacking direction z of the stack 160, 170 of the first resin portion 120 may be different compared to the thickness of the second resin portion 130.

The first cavities 166 of the first stack 160 are opened on a first main surface of the first stack 160 and the second cavities 176 are opened on a second main surface of the second stack 170 and face the first main surface of the first stack 160.

Since the first cavities 166 of the first stack 160 are open towards the first resin portion 120, material of the first resin portion 120 flowed/extended into said first cavities 166, thereby filling up the first cavities 166 and covering the sidewalls and the top surfaces of the embedded first components 165. As a result, the first resin portion 120 is arranged partially in gaps 167 of the open first cavities 166 between the first components 165 and the first stacks 160.

Since the second cavities 176 of the second stack 170 are open towards the second resin portion 130, material of the second resin portion 130 flowed/extended into said second cavities 176, thereby filling up the second cavities 176 and covering the sidewalls and the top surfaces of the embedded second components 175. As a result, the second resin portion 130 is arranged partially in gaps 177 of the open second cavities 176 between the second components 175 and the second stack 170.

It can be seen that a first volume of said gaps 167 in the first cavity 166 is different from a second volume of said gaps 177 in the second cavity 176. Alternatively, the first volume of said gaps 167 in the first cavity 166 may be similar, in particular the same, as a second volume of said gaps 177 in the second cavity 176. Specifically, there are more gaps in the first stack 160, since a higher number of cavities 166 is provided. Furthermore, the combined volume of first gaps 167 is higher than the combined volume of second gaps 177.

Electrically conductive vertical through-connections 151 are formed through the whole component carrier 150 and respectively electrically connect electrically conductive structures 169 on the top main surface of the component carrier 150 with electrically conductive structures 179 at the bottom main surface of the component carrier 150. Accordingly, these electrically conductive vertical through-connections 151 respectively extend through the first stack 160, the intermediate layer 100, and the second stack 170.

In an embodiment, there can be used buried vias (not shown) in the multilayer core, e.g. to connect the first component 164 to the first electrically conductive structure 169 and respective buried vias connecting the second component 174 to the second electrically conductive structure 179 as intermediate connections into a complex multilayer structure. Such a structure can be coexisting with structures 151, e.g. in a mixed level of connection enabling different level of intra-connectivity within the different circuit structures placed onto each core. In an embodiment, the blind vias may not perforate the whole stack 150. The blind vias may be realized e.g. as drilled holes filled with conductive material, for example copper by plating.

The first components 165 and the second components 175 are offset (shifted) with respect to each other along the vertical direction (with respect to a vertical axis z along the stacking/thickness direction), in order that in plain view a (projected) area of the first component 165 does not overlap with a (projected) area of the second component 175. Additionally or alternatively, the first components 165 and second components 175 may be located in the component carrier 100 such, that the respective (projected) area of the first component 165 may at least partially overlap with the respective (projected) area of the second component 175 in a plain view. In the example of Figure 1A, the electrically conductive vertical through-connections 151 function as spatial separators between components 165, 175, thereby dividing the component carrier 150 in a plurality of component regions, wherein these regions do not overlap in the vertical direction. In other words, the first cavity 166 and the second cavity 176 are laterally displaced (without overlap) with respect to each other, in particular with respect to the vertical direction (z).

If the two cavities can be overlapped, the components in the cavities can be directly connected like by vias/bumps/even other components, to reduce the electrical transmission path.

As can be seen by Figure 1A, the first outer electrically conductive layer structure 169 is connected to the first component 165 via the electrically conductive vertical through connection 151 and/or the second outer electrically conductive layer structure 179 is connected to the second component 175 via the electrically conductive vertical through connection 151. Additionally or alternatively, the first outer electrically conductive layer structure 169 is connected to the second component 175 via the electrically conductive vertical through connection 151 and/or the second outer electrically conductive layer structure 179 is connected to the first component 165 via the electrically conductive vertical through connection 151. Optionally, further electrically conductive layer structure(s) and/or further electrically insulating layer structure(s) may be applied on at least one exposed surface. Said optionally further electrically conductive layer structure(s) and/or further electrically insulating layer structure(s) may comprise a surface finish, for example a solder resist or gold.

In a further embodiment, there can be at least one first cavity in the first stack 160 and/or at least one second cavity in the second stack 170 which is not open and/or not facing towards the intermediate layer 100 (not shown).

In an embodiment, the first stack 160 comprises a thickness regarding stack thickness direction (z) in the range from 50 µm to 750 µm, in particular in the range from 80 µm to 500 µm. In a further embodiment, the second stack 170 comprises a thickness regarding stack thickness direction (z) in the range from 80 µm to 1000 µm, in particular in the range from 120 µm to 700 µm. Preferably, the thickness of the second stack 170 is bigger than the thickness of the first stack 160. Alternatively, the thickness of the second stack 170 may be the same or smaller than the thickness of the first stack 160. In an embodiment, the intermediate layer 100 comprises a thickness regarding stack thickness direction (z) in the range from 20 µm to 500 µm, in particular in the range from 50 µm to 300 µm. In an example, the intermediate layer 100 is smaller than the first stack 160 and/or the second stack 170. Alternatively, the intermediate layer 100 may the same or bigger than the first stack 160 and/or the second stack 170. In an example, the first stack 160 comprises more first gaps 167 than the second gaps 177. Alternatively, the first stack 160 comprises the same amount or less first gaps 167 than the second gaps 177.

**Figure 1B** shows a component carrier 150 comparable to the one of Figure 1A with the difference being that the first components 165 and the second components 175 overlap with respect to each other along the vertical direction (z). On the left side, it can be seen that a first component 165 is arranged directly above (on top of) a respective second component 175, hence these components 165, 175 are located at the same vertical axis through the stack. At the right side, a further first component 165 overlaps partially with a respective further second component 175, since only a part of each component 165, 175 is located on the same vertical axis. Thus, the first cavity 166 and the second cavity 176 partially overlap one to each other along the vertical direction (z).

**Figures 2A to 2C** show a first part of a manufacture process of a component carrier 150, according to an exemplary embodiment of the invention. Figure 2A describes a first process flow to provide the first stack 160, Figure 2B shows the intermediate layer 100 as an inlay structure, and Figure 2C illustrates a second process flow to provide the second stack 170.

**Figure 2A****:** a first core is provided that comprises a (fully cured) core layer 162 as a first electrically insulating layer structure, sandwiched between two first electrically conductive layers 164 (e.g. copper foils). The upper electrically conductive layer 164 is patterned to form an electrically conductive layer structure 164 (metal traces), while the lower electrically conductive layer 164 is fully removed (both done by etching). Then, first cavities 166 are formed, e.g. by (laser) drilling, and the bottom of the first cavities 166 (and the first core layer 162) is covered by an adhesive layer 168 (e.g. adhesive temporary component carrier). Afterwards, a respective first component 165 is placed into each first cavity 166 directly onto the adhesive layer 168. When this semi-finished product (first stack 160) is turned around (flipping), the first components 165 are held in place by the adhesive layer 168. It can be seen that each first cavity 166 is open at a first main surface of the first stack 160.

**Figure 2B****:** the intermediate layer 100 is provided as a stand-alone structure (inlay) and may be manufactured according to the process described in Figure 4. The intermediate layer 100 comprises a stiffening layer 110 with stiffeners (e.g. a glass fiber mesh) embedded in an intermediate resin matrix. Said stiffening layer 110 is sandwiched between a first resin portion 120 (here a first resin layer), arranged at a first main surface 115 of the stiffening layer 110, and a second resin portion 130 (here a second resin layer), arranged at a second main surface 116 of the stiffening layer 110. Hereby, the first resin portion 120 and the second resin portion 130 are not fully cured (e.g. in a B-stage), so that the resin of said portions 120, 130 is at least partially flowable (in particular under the influence of temperature/pressure).

In an embodiment, the total volume of the first resin portion 120 is larger than the total volume (of the sum) of the first gaps 167 and/or the total volume of second resin portion 130 is larger than the total volume (of the sum) of the second gaps 177. This may bring the advantage of void free filling the first gaps 167 and/or second gaps 177 which enhances the integrity of the component carrier 150.

**Figure 2C****:** a second core is provided that comprises a (fully cured) core layer 172 as a second electrically insulating layer structure, sandwiched between two second electrically conductive layers 174 (e.g. copper foils). The upper electrically conductive layer 174 is patterned to form an electrically conductive layer structure 174 (metal traces), while the lower electrically conductive layer 174 is fully removed (both done by etching). Then, second cavities 176 are formed, e.g. by (laser) drilling, and the bottom of the second cavities 176 (and the second core layer 172) is covered by an adhesive layer 178 (e.g.). Afterwards, a respective second component 175 is placed into each second cavity 176 directly onto the adhesive layer 178. The second components 175 are now held in place by the adhesive layer 178. It can be seen that each second cavity 176 is open at a second main surface of the second stack 170.

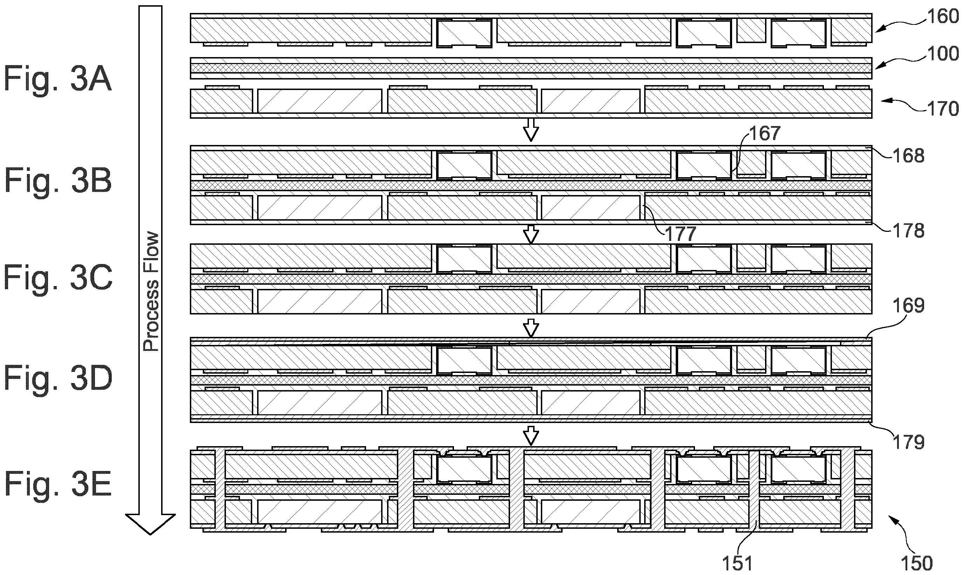

**Figures 3A to 3E** show a second part of a manufacture process of a component carrier, according to an exemplary embodiment of the invention.

**Figure 3A****:** the first stack 160 (manufactured in Figure 2A), the intermediate layer 100 (provided in Figure 2B, for the manufacture see Figure 4), and the second stack 170) are provided on top of each other.

**Figure 3B****:** said three layer 160, 100, 170 are pressed together in a lamination process, wherein heat and/or pressure are applied. During the lamination process, the first resin portion 120 (of the intermediate layer 100) at least partially flows into the first cavities 166 of the first stack 160. Thereby, the first components 165 become fully embedded (encapsulated) by the first resin portion 120. In particular, sidewalls and the top main surface of the components 165 (first gaps 167) are covered by the first resin portion 120. In the same manner, the second resin portion 130 (of the intermediate layer 100) at least partially flows into the second cavities 176 of the second stack 170. Thereby, the second components 175 become fully embedded (encapsulated) by the second resin portion 130. In particular, sidewalls and the top main surface of the components 175 (second gaps 177) are covered by the second resin portion 130.

**Figure 3C****:** the adhesive layers 168, 178 can be removed, since the components 165, 175 are now encapsulated in resin 120, 130 and are thereby hold in place.

**Figure 3D****:** in a further lamination step, additional electrically insulating layer structures (e.g. prepreg) are provided on top and bottom of the multi-stack. These additional electrically insulating layer structures may already comprise respective outer electrically conductive layers 169, 179, or the later can be further provided, e.g. by plating.

**Figure 3E****:** said outer electrically conductive layers 169, 179 are patterned (e.g. by etching) to form outer electrically conductive layer structures 169, 179 (metal traces). By (mechanical) drilling, through-holes are formed which are then filled with electrically conductive material (e.g. copper) to form electrically conductive vertical through connections 151. In this example, the electrically conductive vertical through connections 151 extend through the whole component carrier 150 and electrically connect a first electrically conductive layer structure 169 on top of the component carrier 150 with a second electrically conductive layer structure 179 at the bottom of the component carrier 150. The finished component carrier 150 is a multi-core stack with two core layers, each comprising embedded components 165, 175. Hereby, the first components 165/first cavities 166 and the second components 175/second cavities 176 do not overlap in a vertical direction (along the stacking direction).

**Figures 4A to 4E** show a manufacture process of an intermediate layer 100, according to an exemplary embodiment of the invention.

**Figure 4A****:** the stiffening layer 110 is provided as a prepreg sheet with glass-cloth. The first resin portion 120 and the second resin portion 130, are provided as a respective resin sheet, covered on top with a protective foil (for example comprising polyethylene terephthalate (PET)) 121, 131 and at the bottom with a further protective foil (for example biaxially oriented polyethylene terephthalate (BoPET))122, 132.

**Figure 4B****:** the respective further foils 122, 132 are removed.

**Figure 4C****:** in a lamination step, the first resin portion 120 and the second resin portion 130 (both without the further protective foil 122, 132) are provided to sandwich the stiffening layer 110.

**Figure 4D****:** after said lamination step, the protected intermediate layer 100 can be stored (cold) as an inlay for further application.

**Figure 4E****:** when the protected intermediate layer 100 is used (e.g. for the process described in Figures 2 and 3), the protective foils 121, 131 are removed to provide the intermediate layer 100 for further lamination processes, e.g. according to Figures 2 and 3.

### Reference signs

- 100: Intermediate layer
- 110: Stiffening layer
- 115: First main surface
- 116: Second main surface
- 120: First resin portion/layer
- 121: First PET protective layer
- 122: First mylar protective layer
- 130: Second resin portion/layer
- 131: Second PET protective layer
- 132: Second mylar protective layer
- 150: Component carrier
- 151: Electrically conductive vertical through connection
- 160: First stack
- 162: First electrically insulating layer structure, first core layer
- 164: First electrically conductive layer structure
- 165: First component
- 166: First cavity
- 167: First gaps
- 168: First adhesion layer
- 169: First outer electrically conductive layer structure
- 170: Second stack
- 172: Second electrically insulating layer structure, second core layer
- 174: Second electrically conductive layer structure
- 175: Second component
- 176: Second cavity
- 177: Second gaps
- 178: Second adhesion layer
- 179: Second outer electrically conductive layer structure

## Claims

1. A component carrier (150), wherein the component carrier (150) comprises:
a first stack (160) comprising at least one first electrically conductive layer structure (164) and at least one first electrically insulating layer structure (162), and having a first cavity (166) in which a first component (165) is embedded, wherein said first cavity (166) is open on a first main surface of the first stack (160);
a second stack (170) comprising at least one second electrically conductive layer structure (174) and at least one second electrically insulating layer structure (172), and having a second cavity (176) in which a second component (175) is embedded,
wherein the second cavity (176) is open on a second main surface of the second stack (170) and faces the first main surface of the first stack (160);
an intermediate layer (100), wherein the intermediate layer (100) is arranged between the first stack (160) and the second stack (170), and comprises:
a stiffening layer (110) comprising a stiffening structure in an intermediate resin portion (110),
a first resin portion (120) arranged at a first main surface (115) of the stiffening layer (110),
wherein the first resin portion (120) is arranged at least partially in gaps (167) of the open first cavity (166) between the first component (165) and the first stack (160), and
a second resin portion (130) arranged at a second main surface (116) of the stiffening layer (110) opposed to the first main surface (115), wherein the second resin portion (130) is arranged at least partially in gaps (177) of the open second cavity (176) between the second component (175) and the second stack (170).

2. The component carrier (150) according to claim 1,
wherein the first cavity (166) and the second cavity (176) are laterally displaced with respect to each other, in particular with respect to the vertical direction (z).

3. The component carrier (150) according to claim 2,
wherein the first cavity (166) and the second cavity (176) partially overlap one to each other along the vertical direction (z).

4. The component carrier (150) according to one of the preceding claims, wherein a first volume of said gaps (167) in the first cavity (166) is different from a second volume of said gaps (177) in the second cavity (176).

5. The component carrier (150) according to one of the preceding claims, wherein the stiffening structures of the stiffening layer (110) comprise a plurality of through openings, configured so that the resins of the intermediate resin portion, the first resin portion (120), and the second resin portion (130) are connected one to each other,
in particular wherein the stiffening structure of the stiffening layer (110) comprise stiffening fibres, more in particular wherein the stiffening fibres form a mesh with the plurality of through openings.

6. The component carrier (150) according to claim 5,
wherein the resin of at least one of the intermediate resin portion of the stiffening layer (110), the first resin portion (120), the second resin portion (130), comprises fillers, and
wherein the plurality of through openings is configured to allow the passage of at least a portion of the fillers through said through openings,
in particular wherein the average dimensions of the fillers are lower than the average dimensions of the through openings.

7. The component carrier (150) according to one of the preceding claims, wherein at least one resin of the intermediate resin portion of the stiffening layer (110), the first resin portion (120), the second resin portion (130), has a flow direction towards the first cavity (166) and/or the second cavity (176).

8. The component carrier (150) according to one of the preceding claims, further comprising:
an electrically conductive vertical through connection (151) that passes through at least one of the stiffening layer (110), the first resin portion (120), the second resin portion (130), the intermediate layer (100), the first stack (160), the second stack (170), the whole component carrier (150) stack,
in particular connecting two opposed main surfaces of the component carrier (150).

9. The component carrier (150) according to claim 8,
wherein the electrically conductive vertical through connection (151) connects the first component (165) of the first cavity (166) with the second component (175) of the second cavity (176).

10. The component carrier (150) according to one of the preceding claims, wherein at least one of the intermediate resin portion of the stiffening layer (110), the first resin portion (120), the second resin portion (130), is different to another one of the intermediate resin portion of the stiffening layer (110), the first resin portion (120), the second resin portion (130).

11. The component carrier (150) according to one of the preceding claims, wherein the resin of at least one of the intermediate resin portion of the stiffening layer (110), the first resin portion (120), the second resin portion (130), fills the first gaps (167) and/or the second gaps (177) in the respective cavity (166, 176) up to the opposed surface of the respective stack (160, 170), in particular up to an electrically conductive layer structure (104).

12. A method of manufacturing a component carrier (150), wherein the method comprises:
inserting a first component (165) in a first cavity (166) of a first stack (160) comprising at least one first electrically conductive layer structure (164) and at least one first electrically insulating layer structure (162),
wherein the first cavity (166) is open on a first main surface of the first stack (160);
inserting a second component (175) in a second cavity (176) of a second stack (170) comprising at least one second electrically conductive layer structure (174) and at least one second electrically insulating layer structure (172), wherein the second cavity (176) is open on a second main surface of the second stack (170) and faces the first main surface of the first stack (160);
connecting the first stack (160) with the second stack (170) by an intermediate layer (100) that faces the first main surface of the first stack (160) and the second main surface of the second stack (170), wherein the intermediate layer (100) comprises:
a stiffening layer (110) comprising a stiffening structure in an intermediate resin portion,
a first resin portion (120) arranged at a first main surface (115) of the stiffening layer (110), and
a second resin portion (130) arranged at a second main surface (116) of the stiffening layer (110) opposed to the first main surface (115), wherein the stiffening layer (110), the first resin portion (120), and the second resin portion (130) are at least partially uncured; and
filling at least partially first gaps (167) of the first cavity (166) between the first component (165) and the first stack (160) with material of the first resin portion (120), and second gaps (177) of the second cavity (176) between the second component (175) and the second stack (170) with material of the second resin portion (130), in particular during a resin curing phase.

13. The method according to claim 12, further comprising:
curing at least one of the first resin portion (120), the second resin portion (130), the intermediate resin portion of the stiffening layer (110), at least partially during a component carrier (150) lamination process.

14. The method according to claim 12 or 13, further comprising:
controlling flow of at least one of the first resin portion (120), the second resin portion (130), the intermediate resin portion of the stiffening layer (110), during curing by adjusting at least one characteristic of a mesh openings of the stiffening structures of the stiffening layer (110),
in particular wherein the at least one characteristic of the mesh openings comprises a number of openings per area and/or a size of the openings.

15. The method according to one of claims 12 to 14, further comprising:
controlling flow of at least one of the first resin portion (120), the second resin portion (130), the intermediate resin portion of the stiffening layer (110) by adjusting operation parameters, in particular temperature and/or pressure, during curing.
